(19) Europäisches Patentamt

European Patent Office

Office européen des brevets

(11) **EP 3 267 491 A1**

(12) **EUROPEAN PATENT APPLICATION**

(43) Date of publication:
**10.01.2018 Bulletin 2018/02**

(51) Int Cl.:
*H01L 31/00* [(2006.01)]     *H01B 1/22* [(2006.01)]

(21) Application number: **16001506.1**

(22) Date of filing: **06.07.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Karlsruher Institut für Technologie
76131 Karlsruhe (DE)**

(72) Inventors:
• **Schneider, Monica
  97082 Würzburg (DE)**

• **Willenbacher, Norbert
  67292 Kirchheimbolanden (DE)**
• **Koos, Erin
  76137 Karlsruhe (DE)**
• **Yüce, Ceren
  69190 Walldorf (DE)**

(74) Representative: **Müller-Boré & Partner
Patentanwälte PartG mbB
Friedenheimer Brücke 21
80639 München (DE)**

(54) **PROCESS FOR PRODUCING HIGHLY CONDUCTIVE, PRINTABLE PASTES FROM CAPILLARY SUSPENSIONS**

(57)     The present invention relates to a process for producing highly conductive, printable pastes from capillary suspensions. In particular, the present invention makes use of the capillary suspension phenomenon to design conductive pastes for printed electronic applications, such as front side metallization of solar cells, without non-volatile, organic additives that often deteriorate electrical properties.

**Description**

The present invention relates to a process for producing highly conductive, printable pastes from capillary suspensions. In particular, the present invention makes use of the capillary suspension phenomenon to design conductive pastes for printed electronic applications, such as front side metallization of solar cells, without non-volatile, organic additives that often deteriorate electrical properties.

Producing electronic devices via printing is preferable over other techniques because it is inexpensive and time efficient due to the easy transition to large-scale production with ready availability of industrial devices. This demand for printable electronics is rapidly increasing. Solution-based deposition has become increasingly popular due to the decrease in material wastage and ambient pressure processing at moderate temperatures leading to lower investment costs over other methods such as physical vapor deposition. Printable electronic products range from microscale devices to large scale units, made of either inorganic (e.g. front side metallization of solar cells) or organic material systems (e.g. OLEDs). A large variety of established printing equipment can be used during manufacturing: screen printing, where the ink is pushed through a partially permeable screen; gravure printing or flexography, where the ink is transferred roll to roll; or via drop-on-demand methods like inkjet printing, where the controlled deposition of micro-sized droplets can produce fine structures. Ink formulations have to meet several requirements depending on the printing technique and product application. For example, highly viscous printing pastes are necessary for the screen printing process (0.5-50 Pa·s), whereas inkjet printing requires far lower viscosities (0.001-0.04 Pa·s). Rheological additives, usually polymers, are used to adapt the flow behavior. Furthermore, inks containing insoluble components need a stabilizing agent to avoid sedimentation or agglomeration, such as e.g. alkanethiols on gold nanoparticles. A major disadvantage of these crucial components is the inability to completely remove them in subsequent processing steps (e.g. annealing or sintering/firing). Residues of the additives can detrimentally affect the product properties, e.g. by reducing the conductivity.

Accordingly, the object underlying the present invention is to provide a new concept to produce such highly conductive, printable pastes, thereby overcoming the aforementioned problems in the prior art.

This object and others which will become apparent from the following disclosure, are achieved by the present invention which makes use of the capillary suspension phenomenon to design conductive pastes for printed electronic applications. Adding a small amount of a second, immiscible fluid to a suspension creates a network of liquid bridges between the particles. This capillary force controlled microstructure allows for tuning the flow behavior in a wide range. Yield stress and low-shear viscosity can be adjusted such that sedimentation is inhibited, i.e. long-term stability is provided, and even more importantly narrow line widths and high aspect ratios are accessible. Additionally, these ternary mixtures, so-called capillary suspensions exhibit a strong degree of shear thinning, which allows for conventional coating or printing equipment to be used for application. Finally, the secondary fluid beneficial for stability and processing of the wet paste completely evaporates during drying and sintering. Thus, for example, high purity silver and nickel layers with conductivity two times higher than obtained with state-of-the-art, commercial materials can be obtained.

In particular, the present invention relates to a process for producing highly conductive, printable pastes from capillary suspensions, comprising the steps:

mixing of 5 to 40 volume percent, preferably 25 to 35 volume percent, of a conductive particulate solid, 50 to 94.5 volume percent, preferably 58 to 72 volume percent, of a liquid primary phase, and 0.5 to 10 volume percent, preferably 1 to 7 volume percent, of a liquid secondary phase, in each case related to the total volume of the resulting suspension, with the primary phase and the secondary phase being substantially immiscible with each other, forming a capillary suspension being a three-phase-system solid-liquid-liquid, with the liquid phases being mutually immiscible, with one liquid forming the primary phase and the other liquid forming the secondary phase, respectively, and either the primary or the secondary phase being better wetting in comparison with the solid, so that a highly elastic, gel-like printable paste is formed, with the particle network held together by capillary forces remaining stable and no sedimentation occurring, with the proviso that the process does not involve the use of non-volatile, organic additives and/or polymeric stabilizers, including binders, thixotropic agents, and/or rheology modifiers.

Preferably, the process according to the present invention is carried out by dispersing the conductive particulate solid in the liquid primary phase and then adding the liquid secondary phase to the obtained suspension of the conductive particulate solid and the liquid primary phase. Alternatively, the conductive particulate can firstly be conditioned over the secondary liquid phase to yield respectively conditioned particles with the secondary liquid adsorbed or absorbed thereon. Subsequently, the thus conditioned particles are added to the primary (bulk) liquid phase. Both procedures result in the same rheological behavior for these capillary suspensions.

In a preferred embodiment, the conductive particulate solid is selected from highly conductive particles, particularly inorganic conductive particles, such as nickel, copper, or silver. However, also graphite, carbon black or other conductive organic or conductive organic-inorganic hybride particles can be employed in the present invention.

Preferably, the conductive particulate solid has a medium particle size d50 of 0.1 to 50 $\mu$m, measured by laser

diffraction (in accordance with DIN EN 725-5, ISO 13320) or by impedance measurement method according to ISO 13319 using e.g. a Coulter Counter. The mixing of, or preferably dispersing of the solid constituents of the mixture in the primary phase or secondary phase and addition of the secondary phase can take place by means of suitable kneading or stirring equipment, for example using a ball mill, depending on the starting materials used at rotational speeds in the range of 10 to 2000 rpm, preferably 100 to 2000 rpm, in particular 1000 to 2000 rpm, and at a temperature range of between 10°C and 200°C, preferably between 20°C and 100°C. Typically, a ball mill is used to break up any agglomerates present. The suspension is usually dispersed at high speeds using a dissolver and then, the secondary phase is added thereto, so that a capillary suspension is formed. As a result of the capillary effect a network formation of the particles and droplets of secondary liquid arises.

Most relevant criteria regarding the selection of liquid primary phase and liquid secondary phase is that they are substantially not miscible with each other. In one embodiment of the present invention, a non-polar liquid is used as primary phase and a polar liquid is used as secondary phase. Particularly, the primary phase can be selected from hydrocarbon based compounds being liquid at processing temperature, e.g. molten waxes, including paraffin waxes, carnauba waxes, montan waxes, polyethylene waxes, polypropylene waxes or polyamide waxes, paraffin oil, silicon oil, n-octanol and terpineol. In the course of the present invention, a non-polar solvent will be understood to be such one having a di-electric constant $\varepsilon < 15$, preferably $< 5$ measured at ambient temperature (for example, terpineol: 2.8; octanol: 3.4)). In this embodiment, the secondary phase can particularly be selected from water, glycerol or another hydrophilic water-soluble liquid and mixtures thereof, particularly a DMF/water mixture or glycerol/water mixture, for example a 1:1 mixture thereof. Particularly preferred is a capillary suspension where terpineol is used as primary phase and water or a water/DMF mixture is used as secondary phase.

In an alternative embodiment of the present invention, a polar liquid is used as primary phase and a non-polar liquid is used as secondary phase. Here, for example, glycerol or water including a glycerol/water mixture, more particularly glycerol, can be used as primary phase and terpineol or octanol can be used as secondary phase.

Which of these embodiments is actually adopted, particularly depends on the kind of the conductive particulate solid used, i.e. whether the conductive particulate solid is more hydrophilic or more hydrophobic, e.g. controlled by surface treatment.

To avoid the afore-mentioned impurities produced by the use of non-volatile, organic additives and/or polymeric stabilizers and/or thixotropic agents and/or rheology modifiers in such pastes, a novel formulation strategy based on capillary suspensions has been developed. In capillary suspensions, sedimentation of particles is inhibited by adding small amounts of a secondary liquid to a suspension, which is immiscible with the bulk (primary) phase. The secondary liquid forms a sample-spanning network of particles and droplets, which avoids particle agglomeration, and also dramatically changes the rheological behavior from fluid-like to gel-like or from a weak gel to a strong gel. The viscosity and yield stress of capillary suspensions can be tuned by varying the amount of secondary liquid. Capillary suspensions can be created regardless of whether the secondary liquid wets the solid phase better (pendular state, $\theta < 90°$) or worse than the bulk fluid (capillary state, $\theta > 90°$) where the contact angle $\theta$ is the angle made by the secondary fluid against the particles when surrounded by the bulk fluid. Further, additives become superfluous in this kind of formulation as the capillary network is able to stabilize the particles from sedimentation and also acts as a thickener, which controls the rheological and hence printing properties. As a further advantage, the secondary liquid can be easily removed by evaporation leading to high product purity. The thus obtained formulations/pastes can be used to print fine lines, and more importantly and quite surprisingly the conductivity of the printed and sintered/fired layers is substantially increased compared to the state of the art.

Accordingly, the process according to the present invention further includes the step of applying the thus obtained paste on an electronics' substrate, preferably by means of dispensing, ink jet printing or screen printing, thereby forming layers or lines on such substrates. The thus applied paste will finally be sintered/fired, resulting in an electrical contact layer or structure exhibiting higher conductivity than by means of comparable pastes presently available.

Thus, the present invention is also directed to a solar cell having an electrical contact layer on the face or front of the cell, said electrical contact layer being present in a grid pattern made of finger lines and bus bars produced by applying the paste according to the present invention to a silicon wafer, preferably by screen printing, and firing the silicon wafer.

The Figures show:

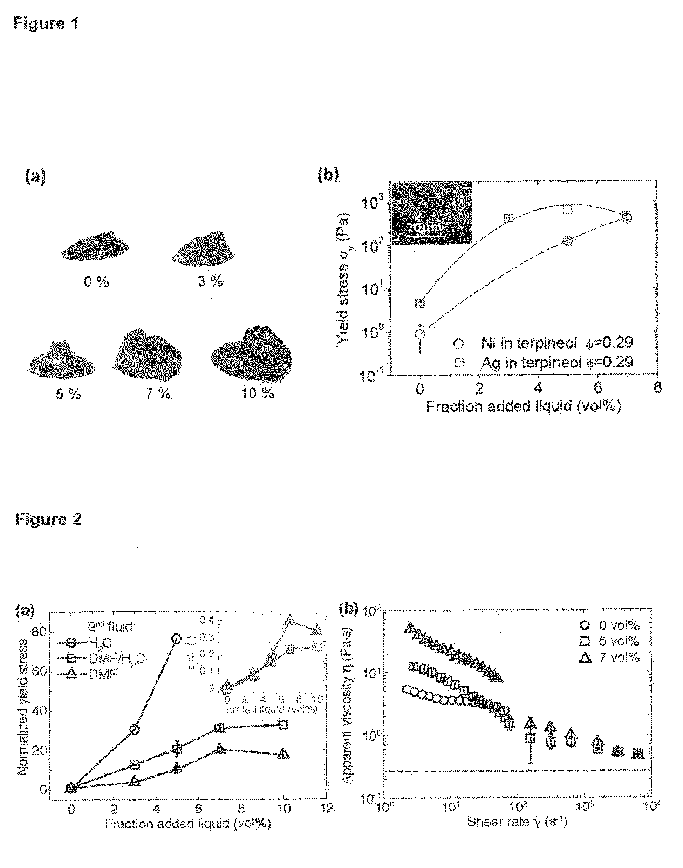

**Figure 1. a)** Nickel particles in paraffin oil ($\phi = 0.20$) with increasing amounts of water-DMF-mixture as a secondary liquid. The samples change from a weak gel without added fluid to a strong, stiff gel with added secondary liquid due to the formation of a capillary state network. **b)** Increase in the yield stress $\sigma_y$ for nickel and silver particles dispersed in terpineol with increasing amounts of distilled water. Both systems are in the capillary state and have a solid volume fraction of $\phi = 0.29$. The inset shows particle-liquid-liquid system in the capillary state. The image was achieved with an index matched system and a confocal scanning laser microscope. The secondary liquid is highlighted in yellow.

**Figure 2. a)** Normalized yield stress as function of secondary fluid content for nickel capillary suspensions with paraffin oil as bulk fluid and different secondary liquids: DMF, DMF/$H_2O$-mixture (1:1 by vol.), and pure $H_2O$. The inset shows the yield stress $\sigma_y$ normalized by the Laplace pressure ($\Gamma/r$). The solid volume fraction for all material combinations shown is $\phi$ = 0.20. **b)** Viscosity $\eta$ of nickel in terpineol suspensions ($\phi$ = 0.29) as function of shear rate $\dot{\gamma}$ for varying water fractions. The dashed line shows the estimated high shear viscosity for the given solid loading assuming hard sphere particles.

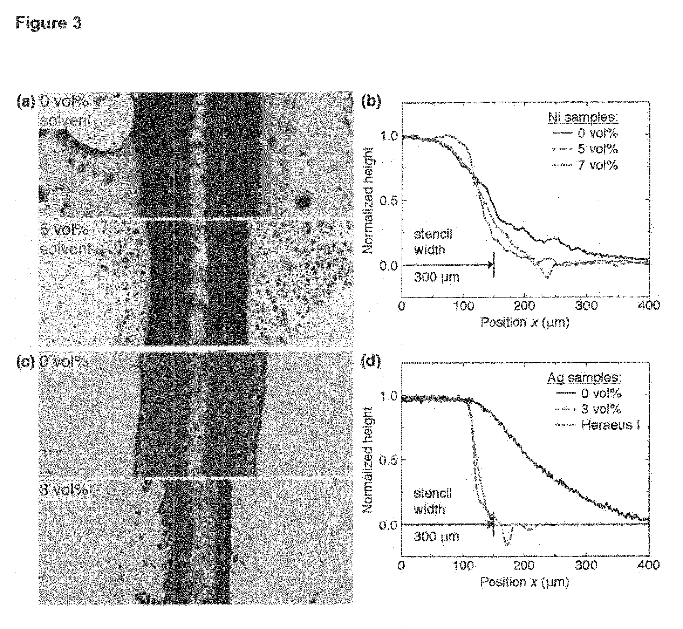

**Figure 3.** Wet contact lines for **a)** nickel and **c)** silver suspensions using a mask of width 300 $\mu$m (red vertical lines). The light grey areas and black spots are from the pure solvent, where the contrast is controlled by the drop height. Cross sectional profile for lines printed with **b)** nickel and **d)** silver capillary suspensions. All suspensions were prepared in terpineol with varying amounts of added water and have a solid volume fraction $\phi$ = 0.29. Additionally, a commercial silver sample (Heraeus I) is plotted for comparison with the silver capillary suspensions.

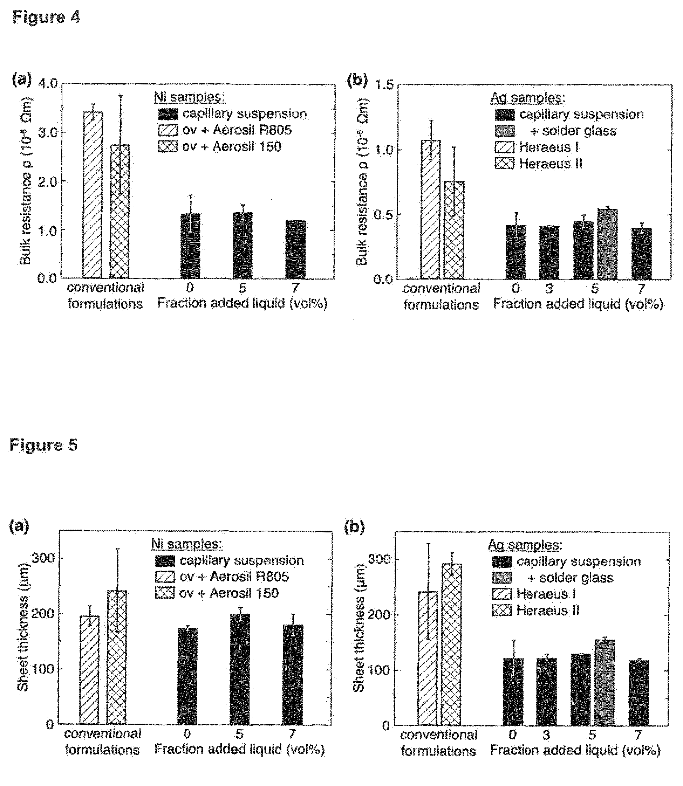

**Figure 4.** Bulk resistance $\rho$ for **a)** nickel and **b)** silver capillary suspensions ($\phi_{Ag/Ni}$ = 0.29) compared to commercial paste formulations. For the nickel, the conventional formulations were prepared according to EP 2 590 177 A2 with an organic vehicle (ov) and two different thixotropic agents (Aerosil R805 and Aerosil 150) using the same particle fraction. Heraeus I and II are commercial silver pastes (solid mass fraction 90.0 and 90.5 wt%, respectively). In addition, a silver capillary suspension with 5 vol% water and 5 wt% solder glass is also shown (total volume fraction of solid phase $\phi_{total}$ = 0.33). Variance in sheet thickness was measured and excluded in the data shown.

**Figure 5.** Sheet thickness obtained for **a)** nickel and **b)** silver capillary suspensions ($\phi_{Ag/Ni}$ = 0.29) compared to commercial paste formulations. For the nickel system, the conventional formulations were prepared according to EP 2 590 177 A2 (ref) using an organic vehicle (ov) and two different thixotropic agents (Aerosil R805 and Aerosil 150) using the same particle fraction. Heraeus I and II are commercial silver pastes (solid mass fraction 90.0 and 90.5 wt%, respectively). In addition, data for a silver capillary suspension with 5 vol% water and 5 wt% solder glass is also shown ($\phi_{total}$ = 0.33).

The invention is described in more detail, but not limited to the following examples. The present invention is particularly applicable for nickel and silver, but can be easily adopted to other inorganic particulate systems.

**EXAMPLES**

Materials and Methods

To create the capillary suspensions, the metal particles were first dispersed into the appropriate non-polar solvent and then water or water/DMF mixture was added. Details about the combinations used are summarized in Table 1 and details about the particles and solvents in Table 2. The particle quantity, (specified by the desired volume fraction), was added to the bulk phase while slowly stirring with a turbulent beater blade. After adding the solids, the stirrer speed was increased to 1000 rpm for 20 minutes to ensure homogenization. Finally, the capillary network formation was induced by adding the secondary liquid volume with a pipette and stirring at high speed for another 5 minutes. An additional sample using a combination of silver particles and solder glass was prepared as above where the volume of silver particles was supplemented by an additional 6 vol% solder glass. The samples were prepared using distilled water with the exception of the data shown in **Figure 2a,** which were also prepared using DMF and a DMF/water mixture.

To compare the rheological and electronic properties of the capillary suspension based products with conventional formulations, additional silver and nickel samples were used. The silver samples, obtained from Heraeus Precious Metals (Hanau, Germany), are referred to as Heraeus I (SOL9610A, 90.5 $\pm$ 1 wt% solids) and Heraeus II (SOL9020C, 90 $\pm$ 1.5 wt% solids). Additionally, two nickel samples were prepared following the disclosure of EP 2 590 177 A2 for an organic vehicle. This organic vehicle contained 60 wt% terpineol as solvent. To this solvent, a polymeric stabilizer (5 wt% polyvinylpyrrolidone K30, average $M_w$=40,000 g/mol, Sigma-Aldrich, Steinheim, Germany), a dispersing agent (20 wt% TEGO Dispers 656, Evonik, Essen, Germany), a cellulose based binder (10 wt% sodium carboxymethylcellulose CRT 200PA, DOW Europe GmbH, Bomlitz Germany) as well as 5 wt% dispersing and thixotropic agent with either hydrophilic (Aerosil 150, Evonik, Essen, Germany) or hydrophobic properties (Aerosil R805, Evonik) were added. The components were homogenized by slowly stirring with a turbulent beater blade (370 rpm) at a constant temperature of 70°C for two hours. After preparation, the organic vehicle was cooled to room temperature. The nickel particles (Alfa Aesar, Nickel powder 3-7$\mu$m, Karlsruhe, Germany) were added to the organic vehicle and the sample was stirred for another 30 minutes at 400 rpm. The nickel particles and their volume fraction were the same as in the capillary suspensions ($\phi_{Ni}$ = 0.29).

The three phase contact angle $\theta$ was used to characterize the solid-liquid-liquid system and the network type of the capillary suspensions. The contact angle of the nickel capillary suspensions was determined using a sintered nickel film placed in a glass container and covered with the bulk fluid. A droplet of distilled water was placed on the surface of a film using a syringe and the resulting three phase contact angle θ of the secondary fluid against the solid evaluated *via* image analysis (Krüss, Drop Shape Analysis, Hamburg, Germany). Surface roughness of the nickel film was negligible compared to droplet size. For the contact angle in silver capillary suspensions, the nickel film was replaced by a smooth commercial silver foil (Dukatshop, silver foil 999/1000 purity, Berlin, Germany). The three phase contact angles were all greater than 90° (130° for nickel particles in terpineol with added water and 156° for silver) placing these suspensions in the capillary state.

The yield stress of each suspension was determined using a rotational rheometer (Mars II, Thermo Scientific, Karlsruhe, Germany) with a vane geometry (10 mm diameter) placed in a cylindrical cup (Z20 DIN). The temperature was 20°C for all measurements. By applying successively increasing stress values and measuring the resulting deformation, two distinct linear regimes are visible in a double-logarithmic plot. The yield stress is defined as the intersection of the two linear curve fits. Flow curves in the low shear regime were obtained using a rough sandblasted aluminum plate (35 mm diameter) and strain-controlled measurement procedure. Increasing strain values were applied stepwise and the resulting shear rate measured after a waiting time of 30 seconds. Viscosity measurements at higher shear rates were completed using a modified Göttfert Rheograph 2000 (Göttfert Werkstoff-Prüfmaschinen GmbH, Buchen Germany) capillary rheometer (capillary length: 40 mm, diameter: 1 mm). The pressure difference measured between sample chamber and capillary outlet was measured with a 200 bar pressure transducer (Gefran, Seligenstadt, Germany) at each selected piston speed and is related to the shear stress. The high shear viscosity can then be determined using this shear stress and the shear rate (related to the flow speed). Further measurement corrections, e.g. for wall-slip, were not performed. Therefore, the high shear data should be treated as apparent viscosity values rather than the true viscosity of the sample.

Films with a defined area were created in order to measure the sheet resistance resulting from the different formulations via doctor blade. The doctor blade gap height was 300 $\mu$m and accurate shapes of 1 cm$^2$ were achieved by confining the pattern with a 60 $\mu$m thick adhesive tape, which was removed promptly after film application. The suspensions were coated on heat stable quartz carriers (PELCO Quartz Substrate Discs, Ted Pella Inc., Redding, Calif.). The nickel and silver films were both sintered at 800°C with the fastest available heating rate of 15 K/min in order to imitate the temperature profile of a belt furnace, which is usually utilized in solar cell production. After arriving at the maximum temperature, the samples cooled down with purely passive cooling. A nitrogen atmosphere was employed to sinter the nickel samples in order to avoid any further oxidation during the sintering step. Ambient air was used for the silver samples. Sheet resistance measurements were completed following the Van-der-Pauw method using a self-constructed measurement set-up, starting from an injected current of 0.02 mA and gradually increasing this value up to 0.1 mA. For better contacting of the nickel samples small droplets of a commercial fast-drying silver paste (Electrodag 1415M, Acheson Colloiden B.V., Scheemda, Netherlands) were placed at each corner of the nickel film. The sheet thicknesses after the sintering process are required for the evaluation of the sheet resistance (to avoid any errors due to the different thicknesses) and were measured with a 3D laser microscope (VK-X100 Laser Microscope, Keyence, Neu-Isenburg, Germany). For printing of fine lines, the adhesive tape was replaced by a glass stencil (171 $\mu$m thickness) with a 300 $\mu$m line width. After squeezing the sample through the stencil with a blade, the stencil was carefully removed and the height profile examined with the 3D laser microscope.

1. Dispersion of nickel and silver particles

Nickel layers have been applied, e.g., in multilayer capacitors in order to reduce production costs by replacing the internal electrodes with cheaper base metal electrodes, or as porous electrodes for molten carbonate fuel cells (MCFCs). Silver particle based pastes are employed in the manufacture of the front side metallization of silicon solar cells as well as other specialized applications. In photovoltaic industries, silver pastes are most commonly applied by screen printing with the aim to print narrow contact lines (≈30 $\mu$m) with increased aspect ratio (height to width ratio) in order to increase efficiency of the solar cell by reducing grid shading loss. As silver is an expensive raw material, but required to achieve a desired conductivity, strong efforts have been made to improve paste formulation as well as printing technology aiming at uniform lines with optimized cross-sectional shape thus minimizing silver consumption.

The conductive pastes must be stable when stored despite the large difference in density between the inorganic particles and bulk solvent. Such storage often occurs at rest or under very low shear rates (e.g., mild agitation). Therefore, the inks must either have a high viscosity in the low-shear regime, which decreases the sedimentation rate, or better yet, by having a yield stress directly preventing particle mobility.

The sample-spanning particle network present in capillary suspensions is able to fulfill these requirements as can be easily seen from the change in texture shown in Figure 1a for a nickel in paraffin oil suspension with increasing amounts of added secondary liquid, here a mixture of the dimethylformamide (DMF) and water (1:1 by volume). The pure suspension with 20 volume percent solid is a weak gel. With increasing amounts of the secondary liquid mixture (3 - 10 vol%), the weak gel changes to a strong and stiff gel with clearly different texture. This textural difference is indicative of a high yield stress where the sample-spanning network is able to hold the weight of the sample and prevent particle sedimentation during, e.g., storage.

Long term stability of capillary suspensions was investigated, showing that the stability is affected when exposing the samples to high temperatures (~100°C) for several days. In this case the capillary network collapses due to the evaporation of the secondary fluid. Nevertheless, the original sample properties, e.g. yield stress, were easily regained after adding equivalent amounts of secondary liquid. This is a major advantage compared to aging issues in conventional conductive pastes linked to the degradation of polymeric additives. Typical storage temperatures of ~20-25°C do not affect the long term stability.

2. <u>Nickel and silver particles dispersed in terpineol</u>

In exemplary embodiments produced in accordance with the present invention, nickel and silver particles were dispersed in terpineol, a solvent commonly used in printing pastes for front side metallization of solar cells to study the change in flow behavior due to an added secondary liquid systematically. The employed solid volume percentage of 29% (≈82 wt% Ag and ≈80 wt% Ni, respectively), is in the range of the solid fractions commonly applied in such pastes (60-95 wt%). Adding the secondary liquid, for instance distilled water, leads to a strong increase in the suspension yield stress $\sigma_y$ as can be seen in **Figure 1 b.** A polynomial fit of second-order was added as guide for the eye. The yield stress of the pure suspension is 5 Pa for silver and 1 Pa in case of the nickel, respectively. This value increases by 400-fold for nickel and 140-fold for silver when adding 7 vol% and 5 vol%, respectively, of secondary liquid as measured to the total liquid volume. Distilled water does not preferentially wet the nickel or silver particles in terpineol, forming contact angles of 130° and 156° placing these mixtures in the capillary state. An example for the three-dimensional network of a capillary state network system is shown in the inset in **Figure 1 b.** This image was achieved with a confocal laser scanning microscope and an index matched particle-liquid-liquid system. The secondary liquid in these capillary state suspensions forms a sample-spanning network between particle clusters and small secondary liquid drops as evident from the strong increase in yield stress with increasing amount of secondary liquid. The capillary network allows for a stabilization of the particles without additional polymeric stabilizers, which are commonly used in other paste formulations, maintaining homogeneous mixtures during storage. Experiments with other systems have shown that capillary suspensions remain stable for long periods, even months, without phase separation.

3. <u>Capillary network investigations</u>

The strength of a capillary network is directly linked with the interfacial tension between the bulk (liquid primary phase) and secondary liquid. As such, a variation of the secondary liquid, including e.g. solvent mixtures, opens another possible route to adjust the flow behavior in order to meet the requirements of the desired printing technique or to improve the quality of the print in addition to varying the solids loading. In order to demonstrate the universality of the capillary suspension phenomenon experiments were conducted with different solvent combinations.

**Figure 2a** shows the influence of the secondary liquid for nickel capillary suspensions with 20 volume percent in paraffin oil and three different secondary liquids: pure DMF, a DMF and water mixture (1:1 by volume), and pure water. The particle diameter of the nickel particles used was in the range from 3-7 $\mu$m which is a typical size range for particles used in pastes for printing silver or nickel electrodes. The corresponding interfacial tension data for these combinations can be taken from Table 1.

The yield stress $\sigma_y$ of a capillary suspension is given by

$$\sigma_y = f(\phi)g(S, \tilde{s})h(\theta)\,\frac{\Gamma}{r} \tag{1}$$

, where the strength is linearly proportional to the interfacial tension $r$, the reciprocal particle radius $r$, and depends on various functions for the solid volume fraction $\phi$, the secondary liquid amount $S$, the normalized particle separation $\tilde{s}$, and the three-phase wetting angle $\theta$. The function $f(\phi)$ depends on the particle volume fraction $\phi$ and includes the number of capillary bridges per particle. The function $g(S, \tilde{s})$ depends on the amount of the secondary liquid $S$ and the reduced particle separation $\tilde{s}$ and includes the dependence of the network strength on the size and shape of the liquid bridges. The function of the contact angle, $h(\theta)$, is typically predicted to be cos $\theta$ in the pendular state, but is more complex in the capillary state. In this study DMF has the lowest interfacial tension of 6.0 mN/m, followed by the aqueous DMF mixture (15.6 mN/m). Pure water forms the highest interfacial tension with 48 mN/m in the presence of paraffin oil. This trend in interfacial tension corresponds directly to the measured yield stress, i.e. network strength. Pure $H_2O$ provides the steepest increase of the normalized yield stress when increasing the secondary fluid amount. For the case of the

DMF/H$_2$O mixture, a maximum in network strength is reached with 7 vol% added liquid followed by a plateau of the yield stress. The pure DMF also has a maximum in the normalized yield stress at 7 vol%, but shows a loss in network strength at higher added fluid contents. The yield stress values for the aqueous DMF capillary suspensions are higher than the pure DMF capillary suspensions at each secondary fluid content due to the higher interfacial tension. This direct influence of the interfacial tension $\Gamma$ can also be seen in the inset to **Figure 2a** showing the yield stress $\sigma_y$ normalized by the Laplace pressure $\Gamma/r$, where $r$ is the mean particle radius, which is constant for the depicted material systems.

The curves shown in **Figure 2a** overlap at low secondary fluid content, but the DMF and DMF/H$_2$O data diverge at higher amounts of added secondary fluid. This divergence might be due to differing cluster structures presumably occurring at higher secondary fluid content. According to Equation 1, yield stress is directly proportional to the interfacial tension, which is clearly evident from the inset in **Figure 2a.** Capillary suspension rheology is easily tuned by adapting the interfacial tension and switching to an appropriate secondary liquid.

During the application or coating step, the inks are subjected to high shear rates that vary strongly with the chosen printing technique (e.g., screen printing $\dot{\gamma} \approx 100$ s$^{-1}$, dispensing $\dot{\gamma} \approx 10,000$ s$^{-1}$) followed by a deformation rate close to zero when the ink settles on the substrate. Therefore, the inks are required to exhibit low high-shear viscosity that allows the ink to easily flow when passing through the screen mesh or dispensing nozzle during application while also possessing a high low-shear viscosity and a fast network recovery providing good shape accuracy to the printed structure. **Figure 2b** shows the rheological response of the capillary suspensions containing nickel particles ($\phi = 0.29$, volume percentage 29 %) to different shear rates. Measurements at shear rates below 100 s$^{-1}$ were performed in a rotational rheometer and higher shear rates (up to $10^4$ s$^{-1}$) were achieved using a capillary rheometer. The viscosity $\eta$ is strongly dependent on the amount of secondary liquid in the low shear regime ($\dot{\gamma} < 100$ s$^{-1}$). Comparing $\eta$ at $\dot{\gamma} = 10$ s$^{-1}$ shows an increase of one decade for 7 vol% of secondary liquid when compared to the pure nickel suspension. All of the samples shown here demonstrate shear-thinning behavior. In the high shear regime ($\dot{\gamma} > 100$ s$^{-1}$) the viscosity functions of the capillary suspensions begin to coincide and approach a plateau value $\eta = 3.5\eta_{\text{solvent}}$ estimated for the given particle loading of $\phi = 0.29$ using the phenomenological model of Quemada (D. Quemada, Rheol. Acta 1977, 16, 82). This is expected since at these high shear rates, the viscosity should be solely determined by the solid volume fraction and demonstrates that the capillary network is completely broken. The pure nickel suspension is not stable at very higher shear rates, leading to phase separation during the capillary rheometry measurements and these data are excluded from the figure.

4. Application oriented printing test

Capillary suspensions exhibit a high yield stress and pronounced shear thinning. The clear advantage of this unique flow behavior in comparison to the pure metal particle suspension is demonstrated in an application oriented printing test. Corresponding results are shown in **Figure 3.** A top view on the wet contact lines taken directly following the application of the capillary suspension with terpineol continuous phase on a glass substrate with a doctor blade and 300 $\mu$m wide slot stencil is shown in **Figure 3a** for the nickel suspension ($\phi = 0.29$) and **Figure 3c** for the silver suspension ($\phi = 0.29$) with an average maximum line heights of 190 $\pm$ 27 $\mu$m. The top images show the line widths obtained for the suspensions without any secondary liquid and the bottom with added water. **Figure 3b and Figure 3d** show the cross sectional height profiles for nickel and silver capillary suspensions, respectively, normalized to their maximum height. Profiles are plotted as function of the x-position from the center, thus the distinct changes in shape are clearly visible. The pure suspensions both spread on the substrate far beyond the 300 $\mu$m mask (denoted by the vertical lines in the images) with the nickel suspension demonstrating a spreading of the pure solvent beyond the borders of the paste due to the limited stability, i.e. phase separation. For the nickel capillary suspension with 5 vol% added water, less solvent spreads under the glass stencil. Thus solvent loss is reduced and the line width decreases from 1008 $\pm$ 163 $\mu$m with no added secondary liquid in the sample to 500 $\pm$ 37 $\mu$m. The error intervals given here and in the subsequent part of this section reflect the variation of the line width along the printed line, i.e. y-direction. The line width further drops to 470 $\pm$ 28 $\mu$m and the height profile changes from bell-shaped to almost rectangular with a flat top and minimal spreading when 7 vol% of water is added. The dip of the profile with 5 vol% added liquid close to the sample edges are attributed to measurement errors: Surface topology of the crack-free wet lines has been measured with a 3D laser scanning microscope. Negative values can occur due to the reflection of the beam from the bottom interface or imperfections within the substrate instead from the top interface of the glass substrate. This type of error, due to the sharp discontinuity in reflection, occurs at the edge of the printed line and reflective substrate.

A similar correlation of amount of secondary liquid and line width is found for the silver samples (see **Figure 3c and 3d**). Adding just 3 vol% of water to the silver suspension reduces spreading and the line width decreases from 644 $\pm$ 143 $\mu$m to 322 $\pm$ 30 $\mu$m. Moreover, the cross section changes from bell-shaped into a rectangular shape. The required lower amount of secondary liquid corresponds to the higher yield stress of the silver suspensions at a given amount of added liquid compared to the nickel system. Additionally, **Figure 3d** shows the profile of a commercial silver sample (Heraeus I) obtained under similar application conditions. The rectangularity (area under the profile compared to the minimum bounding rectangle) of this profile is 0.74 and the corresponding value for the capillary suspension with 3 vol% added water is 0.67.

This demonstrates that the capillary suspension formulation is competitive to the conventional formulation with regard to shape accuracy but the sharp rectangular profile is achieved at lower particle loading compared to the commercial paste and without non-volatile organic additives. Such a rectangular line profile increases the cross-sectional area while maintaining a small footprint. This should result in a high conductivity when printing, e.g. small scale circuit boards with fine lines.

5. Comparison experiments

Nickel as well as silver capillary suspensions with different amount of secondary fluid were coated on quartz glass substrates and sintered at 800°C in order to compare their electronic properties with those of model Ni and Ag suspensions including different binders and thixotropic agents as well as commercially available silver pastes. The heating rate in the sinter oven was 15 K/min, the fastest heating rate achievable, in order to simulate the firing profile in a belt furnace during photovoltaic production. Variation of the sintering temperature was not performed here. A change of the sintering profile such as an increased maximum sintering temperature can affect the resulting electronic properties, e.g. an increase of the maximum temperature results in lower bulk resistance values for silver based systems but it is assumed that this effect is similar for the different pastes investigated here. The resulting sheet resistance $\rho_s$ after annealing was measured using the Van-der-Pauw method and used to calculate the bulk resistance $\rho = \rho_s \cdot d$ together with the corresponding sheet thicknesses $d$ after annealing. Corresponding data for the systems mentioned above are displayed in **Figure 4.** The bulk resistance of nickel based capillary suspensions along with two other commercial formulations are shown in **Figure 4a** and the silver based suspensions and two commercial silver screen printing inks from Heraeus Precious Metals (denoted as Heraeus I and II) are shown in **Figure 4b.** The capillary suspensions prepared with nickel and silver show no distinct trend with increasing amount of secondary liquid. The average bulk resistance of the nickel capillary suspensions is $\rho_{Ni}$, capillary suspensions =

$$1.3 \pm 0.1 \times 10^{-6} \ \Omega m \ and \ \rho_{Ag, \ capillary \ suspensions} = 0.42 \pm 0.02 \times 10^{-6} \ \Omega m \ for \ the \ silver$$

capillary suspensions.

Obviously, the addition of secondary liquid to the wet suspensions does not affect the electronic properties of the produced nickel and silver layers. Stability can be ensured and the rheology of the paste can be tuned to meet the demands of different printing methods without significantly varying the conductivity. However, these capillary suspension formulations clearly differ from conventional formulations including stabilizer, binder and rheology modifier.

The conventional nickel suspensions were prepared following the disclosure of EP 2 590 177 A2 mentioned above for the formulation of an organic vehicle (abbreviated as ov in the figure) that is used for silver based screen printing pastes, but also suggested for other metal particles such as nickel. The bulk solvent in these formulations was the same as used in the capillary suspensions (terpineol). To the pure nickel-terpineol suspension, polyvinyl pyrrolidon (PVP) is added as an organic binder and surfactant and ethyl cellulose as an additional binder or thickener as described in more detail in the above "Materials and Methods" section. Two common thixotropic agents are then added to this organic vehicle: the hydrophobic Aerosil® R805 or the hydrophilic Aerosil® 150. The pastes were prepared following EP 2 590 177 A2 and were subjected to the same heat treatment used for the capillary suspensions. The bulk resistance of these conventional formulations is increased by a factor of two ($2.8 \pm 1.0 \times 10^{-6}$ $\Omega$m) for the Aerosil 150 and threefold for the Aerosil R805 formulation ($3.5 \pm 0.2 \times 10^{-6}$ $\Omega$m) compared to the nickel capillary suspensions (**Figure 4a**) despite having the same loading of nickel particles. The higher bulk resistance may be attributed to the interference of additive residues in the organic vehicle. This is supported by sheet thickness measurements shown in **Figure 5. Figure 5a** shows the sheet thicknesses of the nickel based suspensions. The capillary suspensions exhibit an average sheet thickness of $185 \pm 13$ $\mu$m and the thickness of the conventional nickel formulations is about 10 % higher according to the increased total solids volume caused by the addition of the non-volatile additives that remain in the layer even after sintering. (The volume fraction of nickel, $\phi_{Ni}$ = 0.29 is the same for both the capillary and conventional formulations).

A similar difference in bulk resistance is found when silver capillary suspensions are compared to commercial silver pastes including additional components, e.g. thixotropic agent, polymeric stabilizer and other additives (**Figure 4b**). The size of the silver particles ($\approx 10$ $\mu$m) was chosen similar to that as in the commercial silver pastes investigated here. The two commercial formulations, Heraeus I and II exhibit a bulk resistance $\rho_{Heraeous \ I}$ = $0.76 \pm 0.27 \times 10^{-6}$ $\Omega$m and $\rho_{Heraeus \ II}$ = $1.1 \pm 0.15 \times 10^{-6}$ $\Omega$m, respectively, that is about double the value of the silver capillary suspensions when coated and sintered under similar conditions. Presumably, the additives in the commercial pastes do not evaporate or decay completely during the firing step and diminish the conductive properties of the silver layer. The additives may have an additional effect on the structure of the sintered layer here. The capillary silver suspensions exhibit a substantially lower sheet thickness (123 $\pm$ 5 $\mu$m) than corresponding nickel samples (185 $\pm$ 13) $\mu$m. With a much higher melting point of 1455 °C (961 °C for silver), the nickel samples do not experience a densification as strong as the silver samples during the sintering procedure applied here. However, the commercial silver pastes exhibit a sheet thickness even higher than the nickel samples and this cannot solely be attributed to the remaining additives or the different particle loading. Based on the solid loading reported by the supplier and assuming that the paste consists of silver and terpineol, it is estimated that an upper limit of silver content $\phi_{Ag}$ = 0.44 and accordingly a sheet thicknesses of 180 $\mu$m is expected for the conventional silver formulations. As shown in **Figure 5b** the measured values of 242 $\mu$m (Heraeus I) and 293 $\mu$m (Heraeus II) exceed this value by far. Therefore, it is hypothesized that the additives prevent a complete collapse of the particle network during sintering. Such a particle network would have fewer particle contacts than the denser capillary suspension layer and, accordingly, a lower conductivity, i.e. higher resistance.

Finally, a silver capillary suspension with 5 vol% added water was prepared containing an additional 6 vol% solder glass ($\phi_{total}$ = 33.4%), which is a crucial component during the firing step in the photovoltaic production for proper contact with the underlying substrate. This additional solid phase does not interfere with the formation of the capillary network and led to an even higher yield stress when compared to the silver capillary suspension with $\phi$ = 0.29 and 5 vol% added water. The bulk resistance increases slightly due to the solder glass (from 0.45 $\pm$ 0.05 $\times$ 10$^{-6}$ $\Omega$m to 0.55 $\pm$ 0.19 $\times$ 10$^{-6}$ $\Omega$m), but is still much lower than for the commercial Heraeus formulations. While maintaining an equivalent stability and contact with the substrate as the commercial formulations, by the present invention, it is possible to decrease bulk resistivity by more than a factor of two.

6. Conclusion

The capillary suspension concept can be used advantageously to stabilize conductive solid particles used in conductive pastes for printed electronic applications without using polymeric or other non-volatile organic additives, which can remain in the sintered part, thereby reducing conductivity. Capillary suspension based silver and nickel pastes suitable for screen printing resulted in an at least twofold higher conductivity of the corresponding sintered layer compared to conventional, commercial pastes processed under similar conditions. The yield stress of these capillary suspensions can be tuned to provide stability of the pastes during storage, processing or application, and the degree of shear thinning can be adjusted to enable easy flow through printing meshes or nozzles. This tunable rheology has been demonstrated using both nickel and silver particles with a combination of bulk solvents and secondary fluids, but can be applied other combinations using inorganic or even organic conductive particles. It has also been shown that the unique flow behavior results in a high shape accuracy of the printed pattern. Lines with almost rectangular cross section are demonstrated. Such lines with a high aspect ratio are desired for small scale circuits and even more complex, e.g. triangular shapes advantageous for the front side metallization of solar cells may also be possible. In addition to these benefits directly related to the unique flow behavior, the capillary suspension concept offers a significant advantage in printed electronic applications due to the lack of non-volatile organic additives. This high purity formulation results in a denser layer with higher conductivity in comparison to conventional formulations.

Beyond the above significant key improvements, the capillary suspension concept offers additional opportunities particularly relevant for printed electronic applications. A wide variety of particle sizes and shapes in addition to possible solvent combinations can be used. This offers not only an additional degree of freedom to obtain a desired flow profile, admixtures of micron and sub-micron sized particles may be used to achieve a more dense particle packing, i.e. increased grain contact area, leading to an improved conductivity. Finally, the secondary fluid may be chosen as a highly efficient reducing agent (e.g. DMF) selectively removing oxidized surface layers in the particle contact regions. It has also shown that the capillary suspension concept is an innovative formulation platform ideally suited to design pastes for printed electronic applications with improved processing and conductivity properties. This formulation method requires less expensive ingredients (e.g. water rather than specialized polymers) and offers a promising pathway to increase the conductivity beyond the twofold increase shown here. The proposed high conductivity formulation concept may even enable silver to be replaced, e.g. in large scale applications like solar cells, by more abundant conductive materials such as copper.

**Table 1.** Particles and solvent combinations used for exemplary capillary suspension formulations according to the present invention along with their interfacial tension. All of the capillary networks were in the capillary state where the secondary liquid does not preferentially wet the particles.

| | Bulk phase | Secondary liquid | Interfacial tension $\Gamma$ [mN/m] | Network type |
|---|---|---|---|---|
| Nickel | | | | |
| | Terpineol | Water | 8.5 | Capillary state |

(continued)

| | Bulk phase | Secondary liquid | Interfacial tension $\Gamma$ [mN/m] | Network type |
|---|---|---|---|---|
| | Paraffin oil | Water | 48.0 | Capillary state |
| | Paraffin oil | DMF/water (1:1) | 15.6 | Capillary state |
| | Paraffin oil | DMF | 6.0 | Capillary state |
| Silver | | | | |
| | Terpineol | Water | 8.5 | Capillary state |

**Table 2.** Particles and solvents used for the capillary suspension formulations along with the product and supplier names.

| Component name | Particle size | Supplier |
|---|---|---|
| Solids | | |
| Nickel spheres<br>*Nickel powder 3-7μm* | 3-7 $\mu$m[1] | Alfa Aesar (Karlsruhe, Germany) |
| Silver particles<br>*Silverpulver GE C50* | 5-15$\mu$m[1] | Doduco (Pforzheim, Germany) |
| Solder glass<br>*lead-free solder glass 8470* | $x_{50} \leq 12\mu$m,<br>$x_{99} \leq 63$ $\mu$m[1] | SCHOTT AG (Mainz, Germany) |
| Nonpolar solvents | | |
| Terpineol<br>*mixture of isomers, anhydrous* | | Sigma Aldrich (Steinheim, Germany) |
| Paraffin oil<br>*low viscosity paraffin oil* | | Carl Roth (Karlsruhe, Germany) |
| Polar solvents | | |
| N,N-Dimethylformamide (DMF) | | VWR Chemicals (Darmstadt, Germany) |
| Distilled water | | |

**Claims**

1. A process for producing highly conductive, printable pastes from capillary suspensions, comprising the steps:

mixing of 5 to 40 volume percent of a conductive, particulate solid, 50 to 94.5 volume percent of a liquid primary phase, and 0.5 to 10 volume percent of a liquid secondary phase, in each case related to the total volume of the resulting suspension, with the primary phase and the secondary phase being immiscible with each other, forming a capillary suspension being a three-phase-system solid-liquid-liquid, with the liquid phases being mutually immiscible, with one liquid forming the primary phase and the other liquid forming the secondary phase, respectively, and either the primary or the secondary phase being better wetting in comparison with the solid, so that a highly elastic, gel-like printable paste is formed, with the particle network held together by capillary forces remaining stable and no sedimentation occurring, with the proviso that the process does not involve the use of non-volatile, organic additives and/or polymeric stabilizers including binders, thixotropic agents and/or rheology modifiers.

2. The process according to claim 1, **characterized by** dispersing the conductive particulate solid in the liquid primary phase and then adding the liquid secondary phase to the obtained suspension of the conductive particulate solid and the liquid primary phase

3. The process according to claim 1 or 2, wherein the conductive particulate solid is selected from inorganic conductive particles, preferably from copper, nickel or silver particles.

4. The process according to any one of claims 1 to 3, wherein the conductive particulate solid has a medium particle size d50 of 0.1 to 50 $\mu$m.

5. The process according to anyone of claims 1 to 4, wherein a non-polar liquid is used as primary phase and a polar liquid is used as secondary phase.

6. The process according to anyone of claims 1 to 5, wherein the primary phase is selected from hydrocarbon based compounds being liquid at processing temperature, particularly molten waxes, including paraffin waxes, carnauba waxes, montan waxes, polyethylene waxes, polypropylene waxes or polyamide waxes, paraffin oil, silicon oil, n-octanol, or terpineol.

7. The process according to anyone of claims 1 to 6, wherein the secondary phase is selected from water, glycerol or hydrophilic water soluble liquid and mixtures thereof, particularly DMF/water or glycerol/water mixtures.

8. The process according to claim 7, wherein terpineol is used as primary phase and water or a water/DMF mixture is used as secondary phase.

9. The process according to anyone of claims 1 to 4, wherein a polar liquid is used as primary phase and a non-polar liquid is used as secondary phase.

10. The process according to claim 9, wherein glycerol or a glycerol/water mixture is used as primary phase and terpineol is used as secondary phase.

11. The process according to anyone of claims 1 to 10, further including the step of applying the thus obtained paste on an electronics' substrate, preferably by means of dispensing, ink jet printing or screen printing, thereby forming layers or lines on such substrate.

12. Highly conductive, printable paste composed of a capillary suspension obtainable by the process according to any one of claims 1 to 11, without any non-volatile, organic additives and/or polymeric stabilizers including binders, thixotropic agents and/or rheology modifiers.

13. Electrical contact layer or structure obtained by applying the paste according to claim 12 on an electronics' substrate, preferably by dispensing, ink jet printing or screen printing, and subsequently firing it.

14. Solar cell having an electrical contact layer on the face or front of the cell, said electrical contact layer being present in a grid pattern made of finger lines and bus bars produced by applying the paste according to claim 12 to a silicon wafer, preferably by screen printing, and firing the silicon wafer.

Figure 1

(a)

0 %    3 %

5 %    7 %    10 %

(b)

Figure 2

(a)

(b)

Figure 3

**Figure 4**

**Figure 5**

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | WO 2014/190125 A1 (DU PONT [US])<br>27 November 2014 (2014-11-27)<br>* page 5, lines 13-19 *<br>* page 4, line 30 - page 5, line 7 *<br>* the whole document *<br>----- | 1-9,<br>11-14<br>10 | INV.<br>H01L31/00<br>H01B1/22 |
| X | EP 2 549 488 A1 (FURUKAWA ELECTRIC CO LTD [JP]) 23 January 2013 (2013-01-23)<br>* example 2 *<br>* claim 4 *<br>* the whole document *<br>----- | 1 | |
| X | US 2016/153092 A1 (LOWENTHAL MARK DAVID [US] ET AL) 2 June 2016 (2016-06-02)<br>* claims 1,7,8 *<br>* paragraphs [0016], [0099] *<br>* the whole document *<br>----- | 1-14 | |
| A | JIAQUAN XU ET AL: "Assembly of metals and nanoparticles into novel nanocomposite superstructures",<br>SCIENTIFIC REPORTS,<br>vol. 3, 25 April 2013 (2013-04-25),<br>XP055315142,<br>DOI: 10.1038/srep01730<br>* figures 1,2 *<br>* the whole document *<br>----- | 1-14 | TECHNICAL FIELDS SEARCHED (IPC)<br><br>H01L<br>H01B |

-/--

The present search report has been drawn up for all claims

| Place of search | Date of completion of the search | Examiner |
|---|---|---|
| The Hague | 1 November 2016 | Ziegler, Jan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 16 00 1506

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | ERIN KOOS: "Capillary suspensions: Particle networks formed through the capillary force", CURRENT OPINION IN COLLOID AND INTERFACE SCIENCE, vol. 19, no. 6, 1 December 2014 (2014-12-01), pages 575-584, XP055315134, GB ISSN: 1359-0294, DOI: 10.1016/j.cocis.2014.10.004 ----- | | |
| A | WO 2010/101418 A2 (LS CABLE LTD [KR]; KIM YOON-JIN [KR]; KO CHANG-MO [KR]; CHO HO-SOUK [K) 10 September 2010 (2010-09-10) * table 1 * * paragraph [0064] * * the whole document * ----- | 1-14 | |

|  | TECHNICAL FIELDS SEARCHED (IPC) |
|---|---|

The present search report has been drawn up for all claims

| Place of search | Date of completion of the search | Examiner |
|---|---|---|
| The Hague | 1 November 2016 | Ziegler, Jan |

EPO FORM 1503 03.82 (P04C01)

## ANNEX TO THE EUROPEAN SEARCH REPORT
## ON EUROPEAN PATENT APPLICATION NO.

EP 16 00 1506

This annex lists the patent family members relating to the patent documents cited in the above-mentioned European search report.
The members are as contained in the European Patent Office EDP file on
The European Patent Office is in no way liable for these particulars which are merely given for the purpose of information.

01-11-2016

| Patent document cited in search report | | | Publication date | Patent family member(s) | | | Publication date |
|---|---|---|---|---|---|---|---|
| WO 2014190125 | A1 | | 27-11-2014 | CN | 105358261 | A | 24-02-2016 |
| | | | | EP | 2999550 | A1 | 30-03-2016 |
| | | | | JP | 2016521908 | A | 25-07-2016 |
| | | | | US | 2014349025 | A1 | 27-11-2014 |
| | | | | WO | 2014190125 | A1 | 27-11-2014 |
| EP 2549488 | A1 | | 23-01-2013 | CN | 102812520 | A | 05-12-2012 |
| | | | | EP | 2549488 | A1 | 23-01-2013 |
| | | | | JP | 5041454 | B2 | 03-10-2012 |
| | | | | KR | 20130061671 | A | 11-06-2013 |
| | | | | US | 2013001774 | A1 | 03-01-2013 |
| | | | | WO | 2011114747 | A1 | 22-09-2011 |
| US 2016153092 | A1 | | 02-06-2016 | NONE | | | |
| WO 2010101418 | A2 | | 10-09-2010 | KR | 20100099970 | A | 15-09-2010 |
| | | | | WO | 2010101418 | A2 | 10-09-2010 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2590177 A2

**Non-patent literature cited in the description**

- **D. QUEMADA.** *Rheol. Acta,* 1977, vol. 16, 82